(19) Europäisches Patentamt
European Patent Office
Office européen des brevets

(11) **EP 4 576 692 A1**

(12) **EUROPEAN PATENT APPLICATION**

(43) Date of publication:
**25.06.2025 Bulletin 2025/26**

(21) Application number: **23219586.7**

(22) Date of filing: **22.12.2023**

(51) International Patent Classification (IPC):
**H04L 27/20** $^{(2006.01)}$    **H03M 13/25** $^{(2006.01)}$
**H04L 1/00** $^{(2006.01)}$    **H04L 27/26** $^{(2006.01)}$

(52) Cooperative Patent Classification (CPC):
**H04L 27/2636; H04L 1/006; H04L 27/2017;**
**H04L 27/2634; H04L 27/2697;** H03M 13/256;
H04L 27/2614; H04L 27/26265

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **Nokia Technologies Oy**
**02610 Espoo (FI)**

(72) Inventors:
• **RENFORS, Markku**
  **Tampere (FI)**
• **TERVO, Oskari**
  **Oulu (FI)**
• **TIIROLA, Esa Tapani**
  **Oulu (FI)**
• **VALKAMA, Mikko**
  **Tampere (FI)**

(74) Representative: **Nokia EPO representatives**
**Nokia Technologies Oy**
**Karakaari 7**
**02610 Espoo (FI)**

(54) **SIGNAL PHASE TRANSITIONS FOR TRANSMISSIONS IN COMMUNICATION NETWORKS**

(57)    According to an example aspect of the present disclosure, there is provided a method comprising generating, for a binary data sequence, a sequence of trellis-coded modulation symbols in a complex Quadrature Phase Shift Keying, QPSK, constellation by means of a trellis code, generating a Discrete Fourier Transform, DFT, -precoded, Orthogonal Frequency Division Multiplexing, OFDM signal based at least on the sequence of trellis-coded modulation symbols and performing a transmission based on the generated DFT-precoded OFDM signal, wherein phase transitions between two successive trellis-coded modulation symbols of the sequence are determined by the trellis code, and wherein an absolute difference between two phase transitions successively-determined by the trellis code is at most $\pi/2$.

FIG. 3a

**Description**

FIELD

Various example embodiments relate in general to communication networks and more specifically, to signal phase transitions for transmissions in such networks.

BACKGROUND

Signal phase transitions for transmissions may be used for example in various cellular communication networks, such as in cellular communication networks operating according to 5G radio access technology. 5G radio access technology may also be referred to as New Radio, NR, access technology. 3rd Generation Partnership Project, 3GPP, develops standards for 5G/NR. There is a need to provide enhanced methods, apparatuses and computer programs related to transmissions in cellular communication networks. Such enhancements may also be beneficial in other wireless communication networks, such as in 6G networks in the future, or in any other suitable wireless communication network.

SUMMARY

According to some aspects, there is provided the subject-matter of the independent claims. Some example embodiments are defined in the dependent claims.
The scope of protection sought for various example embodiments of the disclosure is set out by the independent claims. The example embodiments and features, if any, described in this specification that do not fall under the scope of the independent claims are to be interpreted as examples useful for understanding various example embodiments of the disclosure.
According to a first aspect of the present disclosure, there is provided an apparatus comprising at least one processor, and at least one memory storing instructions that, when executed by the at least one processor, cause the apparatus at least to generate, for a binary data sequence, a sequence of trellis-coded modulation symbols in a complex Quadrature Phase Shift Keying, QPSK, constellation by means of a trellis code, generate a Discrete Fourier Transform, DFT, -precoded Orthogonal Frequency Division Multiplexing, OFDM, signal based at least on the sequence of trellis-coded modulation symbols, and perform a transmission based on the generated DFT-precoded OFDM signal, wherein phase transitions between two successive trellis-coded modulation symbols of the sequence are determined by the trellis code, and wherein an absolute difference between two phase transitions successively-determined by the trellis code is at most $\pi/2$.
Example embodiments of an apparatus according to the first aspect may comprise at least one feature from the following bulleted list or any combination of the following features:

- wherein the trellis code is a two-states recursive trellis code comprising a first state and a second state, wherein a phase transition for generating a respective trellis-coded modulation symbol when transiting from the first state to the second state or from the second state to the first state is equal to 0, wherein a phase transition for generating a respective trellis-coded modulation symbol when transiting from the first state back to the first state is equal to $+\pi/2$, and wherein a phase transition for generating a respective trellis-coded modulation symbol when transiting from the second state back to the second state is equal to $-\pi/2$;
- wherein the apparatus is further caused to determine that a first phase transition for generating a first trellis-coded modulation symbol of the sequence is 0, and determine, based on determining that the first phase transition is 0, that a second phase transition for generating a second successive trellis-coded modulation symbol of the sequence is $-\pi/2$, 0 or $+\pi/2$;
- wherein the apparatus is further caused to determine that a first phase transition for generating a first trellis-coded modulation symbol of the sequence is $-\pi/2$, and determine, based on determining that the first phase transition is $-\pi/2$, that a second phase transition for generating a second successive trellis-coded modulation symbol of the sequence is $-\pi/2$ or 0;
- wherein the apparatus is further caused to determine that a first phase transition for generating a first trellis-coded modulation symbol of the sequence is $+\pi/2$, and determine, based on determining that the first phase transition is $+\pi/2$, that a second phase transition for generating a second successive trellis-coded modulation symbol of the sequence is $+\pi/2$ or 0;
- wherein the apparatus is further caused to insert additional modulation symbols interleaved with the sequence of trellis-coded modulation symbols, wherein the interleaved modulation symbols have a same amplitude as a preceding and successive trellis-coded modulation symbols, and a phase interpolated from phases of the preceding and successive trellis-coded modulation symbols, and generate the DFT-precoded OFDM signal based at least on the sequence of trellis-coded modulation symbols and on the interleaved modulation symbols;
- wherein the apparatus is further caused to generate the DFT-precoded OFDM signal by truncating a DFT-domain sequence to a preferred bandwidth of size $M+E$ DFT bins to an Inverse Fast Fourier Transform, IFFT, input, wherein M denotes a length of the sequence, and $E$ denotes a positive integer with $0 \le E \le M$;
- wherein the $M+E$ DFT bins are centered around a DC bin of the DFT-domain sequence;
- wherein the apparatus is further caused to determine whether a size of an allocation of the transmission in frequency-domain is below a threshold, and perform said insertion when the size of the allocation of the transmission is below or equal to the threshold;
- wherein the apparatus is further caused to determine whether a size of an allocation of the transmission in frequency-domain is below a threshold, and consider the allocation as invalid when the size of the allocation of the transmission is above the threshold;
- wherein the threshold is half of a maximum allocation size of the transmission in frequency-domain;
- wherein the apparatus is further caused to generate one trellis-coded modulation symbol of the sequence of trellis-coded modulation symbols per one bit of the binary data sequence.

According to a second aspect of the present disclosure, there is provided an apparatus comprising at least one processor, and at least one memory storing instructions that, when executed by the at least one processor, cause the apparatus at least to receive a Discrete Fourier Transform, DFT, -precoded Orthogonal Frequency Division Multiplexing, OFDM signal, determine a sequence of trellis-coded modulation symbols from the DFT-precoded OFDM signal, and determine a binary data sequence from the sequence of trellis-coded modulation symbols and based on a trellis code that was used to generate the sequence of trellis-coded modulation symbols, wherein phase transitions between two successive trellis-coded modulation symbols of the sequence are determined by the trellis code, and wherein an absolute difference between two phase transitions successively-determined by the trellis code is at most $\pi/2$.

Example embodiments of an apparatus according to the second aspect may comprise at least one feature from the following bulleted list or any combination of the following features:

- wherein the trellis code is a two-states recursive trellis code comprising a first state and a second state, wherein a phase transition for decoding a respective trellis-coded modulation symbol when transiting from the first state to the second state or from the second state to the first state is equal to 0, wherein a phase transition for decoding a respective trellis-coded modulation symbol when transiting from the first state back to the first state is equal to $+\pi/2$, and wherein a phase transition for decoding a respective trellis-coded modulation symbol when transiting from the second state back to the second state is equal to $-\pi/2$;
- wherein the apparatus is further caused to determine that a first phase transition for decoding a first trellis-coded modulation symbol of the sequence is 0, and determine, based on determining that the first phase transition is 0, that a second phase transition for decoding a second successive trellis-coded modulation symbol of the sequence is $-\pi/2$, 0 or $+\pi/2$;
- wherein the apparatus is further caused to determine that a first phase transition for decoding a first trellis-coded modulation symbol of the sequence is $-\pi/2$, and determine, based on determining that the first phase transition is $-\pi/2$, that a second phase transition for decoding a second successive trellis-coded modulation symbol of the sequence is $-\pi/2$ or 0;
- the apparatus is further caused to determine that a first phase transition for decoding a first trellis-coded modulation symbol of the sequence is $+\pi/2$, and determine, based on determining that the first phase transition is $+\pi/2$, that a second phase transition for decoding a second successive trellis-coded modulation symbol of the sequence is $+\pi/2$ or 0.

According to a third aspect of the present disclosure, there is provided a first method comprising generating, for a binary data sequence, a sequence of trellis-coded modulation symbols in a complex Quadrature Phase Shift Keying, QPSK, constellation by means of a trellis code, generating a Discrete Fourier Transform, DFT, -precoded, Orthogonal Frequency Division Multiplexing, OFDM signal based at least on the sequence of trellis-coded modulation symbols, and performing a transmission based on the generated DFT-precoded OFDM signal, wherein phase transitions between two successive trellis-coded modulation symbols of the sequence are determined by the trellis code, and wherein an absolute difference between two phase transitions successively-determined by the trellis code is at most

Example embodiments of the first method according to the third aspect correspond with the example embodiments of an apparatus according to the first aspect.

According to a fourth aspect of the present disclosure, there is provided a second method comprising receiving a Discrete Fourier Transform, DFT, -precoded Orthogonal Frequency Division Multiplexing, OFDM signal, determining a sequence of trellis-coded modulation symbols from the DFT-precoded OFDM signal, and determining a binary data sequence from the sequence of trellis-coded modulation symbols and based on a trellis code that was used to generate the sequence of trellis-coded modulation symbols, wherein phase transitions between two successive trellis-coded modulation symbols of the sequence are determined by the trellis code, and wherein an absolute difference between two phase transitions successively-determined by the trellis code is at most

Example embodiments of the second method according to the fourth aspect correspond with the example embodiments of an apparatus according to the second aspect.

According to a fifth aspect of the present disclosure, there is provided an apparatus comprising means for generating, for a binary data sequence, a sequence of trellis-coded modulation symbols in a complex Quadrature Phase Shift Keying, QPSK, constellation by means of a trellis code, means for generating a Discrete Fourier Transform, DFT, -precoded, Orthogonal Frequency Division Multiplexing, OFDM signal based at least on the sequence of trellis-coded modulation symbols, and means for performing a transmission based on the generated DFT-precoded OFDM signal, wherein phase transitions between two successive trellis-coded modulation symbols of the sequence are determined by the trellis code, and wherein an absolute difference between two phase transitions successively-determined by the trellis code is at most

Example embodiments of an apparatus according to the fifth aspect correspond with the example embodiments of an apparatus according to the first aspect.

According to a sixth aspect of the present disclosure, there is provided an apparatus comprising means for receiving a Discrete Fourier Transform, DFT, -precoded Orthogonal Frequency Division Multiplexing, OFDM signal, means for determining a sequence of trellis-coded modulation symbols from the DFT-precoded OFDM signal, and means for determining a binary data sequence from the sequence of trellis-coded modulation symbols and based on a trellis code that was used to generate the sequence of trellis-coded modulation symbols, wherein phase transitions between two successive trellis-coded modulation symbols of the sequence are determined by the trellis code, and wherein an absolute difference between two phase transitions successively-determined by the trellis code is at most

Example embodiments of an apparatus according to the sixth aspect correspond with the example embodiments of an apparatus according to the second aspect.

According to a seventh aspect of the present disclosure, there is provided a non-transitory computer readable medium having stored thereon a set of computer readable instructions that, when executed by at least one processor, cause an apparatus to at least perform the first method according to the third aspect or the second method according to the fourth aspect.

According to an eighth aspect of the present disclosure, there is provided a computer program comprising instructions which, when the program is executed by an apparatus, cause the apparatus to carry out the first method according to the third aspect or the second method according to the fourth aspect.

BRIEF DESCRIPTION OF THE DRAWINGS

FIG. 1 illustrates an example of a network scenario in accordance with at least some example embodiments;

FIG. 2a illustrates a first example of bit mapping and phase transition in accordance with at least some example embodiments;

FIG. 2b illustrates a second example of bit mapping and phase transition in accordance with at least some example embodiments;

FIG. 3a illustrates an example of operation of a transmitter in accordance with at least some example embodiments;

FIG. 3b illustrates an example of operation of a receiver in accordance with at least some example embodiments;

FIG. 4 illustrates an example apparatus capable of supporting at least some example embodiments;

FIG. 5 illustrates a flow graph of a first method in accordance with at least some example embodiments; and

FIG. 6 illustrates a flow graph of a second method in accordance with at least some example embodiments.

EXAMPLE EMBODIMENTS

Embodiments of the present disclosure provide improvements for signal phase transitions for transmissions in cellular communication networks. More specifically, embodiments of the present disclosure enable low Peak-to-Average Power Ratio, PAPR, transmissions in such networks.

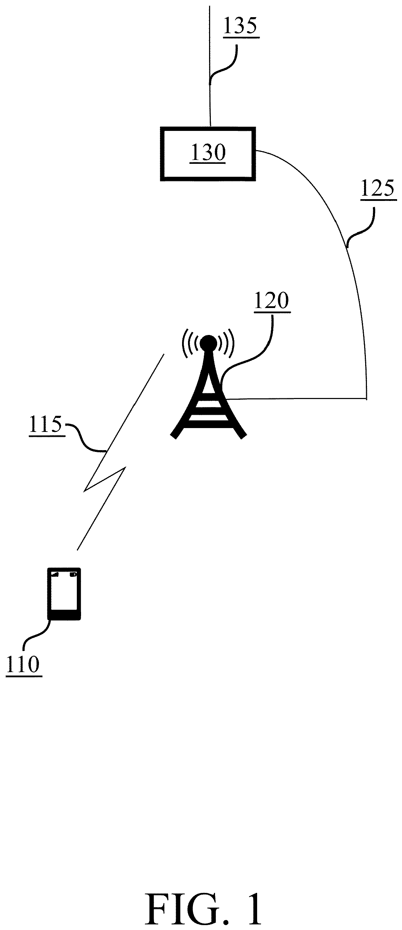

FIG. 1 illustrates an example of a network scenario in accordance with at least some example embodiments. According to the example scenario of FIG. 1, there may be a communication system, which comprises User Equipment, UE, 110, wireless network node 120 and core network element 130. UE 110 may be connected to wireless network node 120 via air interface 115. UE 110 may be connected to wireless network node 120, e.g., by using multiple beams, either simultaneously or one at a time. That is, air interface 115 may be a beam-based air interface.

UE 110 may comprise, for example, a smartphone, a cellular phone, a Machine-to-Machine, M2M, node, Machine-Type Communications, MTC, node, an Internet of Things, IoT, node, a car telemetry unit, a laptop computer, a tablet computer or, indeed, any kind of suitable wireless terminal. Wireless network node 120 may be considered as a serving node for UE 110 and one cell of wireless network node 120 may be a serving cell for UE 110. At least some example embodiments of the present disclosure may be applied in the context of Low Power Wide Area, LPWA.

Air interface between UE 110 and wireless network node 120 may be configured in accordance with a Radio Access Technology, RAT, which both UE 110 and wireless network node 120 are configured to support. Examples of cellular RATs include Long Term Evolution, LTE, New Radio, NR, which may also be known as fifth generation, 5G, radio access technology and MulteFire. In the future 6G may be an example of a cellular RAT as well.

For example in the context of LTE, wireless network node 120 may be referred to as eNB, while wireless network node 120 may be referred to as gNB in the context of NR. In some example embodiments, wireless network node 120 may be referred to as a Transmission and Reception Point, TRP, or control multiple TRPs that may be co-located or non-co-located. In any case, example embodiments of the present disclosure are not restricted to any particular wireless technology. Instead, example embodiments may be exploited in any wireless communication system, wherein phase transitions for transmissions are used.

Wireless network node 120 may be connected, directly or via at least one intermediate node, with core network 130 via interface 125. Core network 130 may be, in turn, coupled via interface 135 with another network (not shown in FIGURE 1), via which connectivity to further networks may be obtained, for example via a worldwide interconnection network. Wireless network node 120 may be connected, directly or via at least one intermediate node, with core network 130 or with another core network.

In some example embodiments, the network scenario may comprise a relay node instead of, or in addition to, UE 110 and/or wireless network node 120. Relaying may be used for example when operating on millimeter-wave frequencies. One example of the relay node may be an Integrated Access and Backhaul, IAB, node. The IAB node may be referred to as a self-backhauling relay as well. Another example of a relay may be an out-band relay. In general, the relay node may comprise two parts:

- Distributed Unit, DU, part which may facilitate functionalities of wireless network node 120, such as a gNB. Thus, in some example embodiments, the DU part of a relay may be referred to as wireless network node 120 and the DU may perform tasks of wireless network node 120;
- Mobile Termination, MT, part which may facilitate functionalities of UE 110, i.e., a backhaul link which may be the communication link between a parent node (DU), such as a DU part of wireless network node 120, and the relay, such as an IAB node. In some example embodiments, the MT part may be referred to as UE 110 and perform tasks of UE 110.

At least some example embodiments of the present disclosure may be described with help of NR specifications and terminology. However, it is noted that the same Radio Frequency, RF, limitations may be faced at least in 6G. Hence, example embodiments of the present disclosure may be applied similarly for 6G, or any other similar system in the future.

Using NR as an example, at least modulation methods such as Quadrature Phase Shift Keying, QPSK, 16 Quadrature Amplitude Modulation, QAM, 64 QAM and even up to 1024 QAM may be used, at least in downlink. However, especially uplink coverage is an important issue. As an example, at least two waveforms may be supported for uplink, such as Orthogonal Frequency Division Multiplexing OFDM, and Discrete Fourier Transform-spread-OFDM, DFT-s-OFDM. DFT-s-OFDM may be exploited to significantly lower PAPR and thus used to achieve better coverage. Further, in uplink it may be possible to configure $\pi/2$ Binary Phase Shift Keying, BPSK, and use Frequency Domain Spectrum Shaping, FDSS, to achieve very low PAPR. On top of that, FDSS may be used with and without spectrum extension, wherein spectrum extension may be exploited to increase coverage for, e.g., for pi/2 BPSK or QPSK modulation.

In the future, at least in 6G, additional coverage solutions may be desired. Additional coverage solutions may be beneficial at least for Enhanced Mobile Broadband, eMBB, for example when operating in the frequency range 6-15 GHz, and also for different LPWA use cases.

Furthermore, $\pi/2$ BPSK with FDSS may provide low PAPR, for example 3dB PAPR reduction at 1% Complementary Cumulative Distribution Function, CCDF, point compared to QPSK. Hence, reduced MPR (i.e., higher radiated power) may be achieved at UE 110. However, even lower PAPR may be desirable. Even in case of modulation methods with constant amplitude symbols, such as BPSK, the amplitude of the generated waveform may have significant variations and there may be sharp phase transitions between consecutive symbols and/or samples. Also, phase discontinuity may appear due to an impact of a Cyclic Prefix, CP, and have an impact on the PAPR and Out-of-band, OOB, characteristics of the waveform. There is therefore a need for a modulation method which minimizes both, PAPR and OOB, because the PAPR and spectrum of the waveform plays an important role in the coverage of the waveform. Lower PAPR may also reduce power consumption of UE 110 at least in certain scenarios. Smaller PAPR may also help in reducing the cost (& complexity) of the transmitter of UE 110. The modulation method of the present disclosure may be used by any wireless transmitter, such as UE 110 or wireless network node 120.

Out-of-band, OOB, emissions (e.g., Adjacent Channel Leakage Ratio, ACLR, or a spectrum emission mask) may limit a coverage area of UE 110 quite quickly either when allocations are not in the centre of the operating band, or if the allocations are large compared to the bandwidth of the operating band. In some example embodiments, allocations of above 50 resource blocks may be considered as large. For example, assuming a channel bandwidth of 20 MHz and subcarrier spacing of 15 kHz, the total number of resource blocks may be 100. In such a case, UE 110 may need and be allowed to apply a large Maximum Power Reduction, MPR, to satisfy the OOB emission limits. It is visible also from the specifications, where MPR requirements have been defined differently for different allocation regions as shown e.g., Table 1.

**Table 1** Maximum power reduction (MPR) for power class 3

| Modulation | | MPR (dB) | | |
|---|---|---|---|---|
| | | Edge RB allocations | Outer RB allocations | Inner RB allocations |
| DFT-s-OFDM | Pi/2 BPSK | $\leq 3.5^1$ | $\leq 1.2^1$ | $\leq 0.2^1$ |
| | | $\leq 0.5^{2,3}$ | $\leq 0.5^2$ | $0^2$ |
| | Pi/2 BPSK w Pi/2 BPSK DMRS | $\leq 0.5^{2,3}$ | $0^2$ | $0^2$ |
| | QPSK | $\leq 1$ | | $0$ |
| | 16 QAM | $\leq 2$ | | $\leq 1$ |
| | 64 QAM | $\leq 2.5$ | | |
| | 256 QAM | $\leq 4.5$ | | |
| CP-OFDM | QPSK | $\leq 3$ | | $\leq 1.5$ |
| | 16 QAM | $\leq 3$ | | $\leq 2$ |
| | 64 QAM | $\leq 3.5$ | | |
| | 256 QAM | $\leq 6.5$ | | |

Even without any shaping, QPSK and $\pi/2$ BPSK for DFT-s-OFDM may be limited by ACLR or Spectral Emission Mask, SEM, for edge allocations, and even for inner allocations if the allocation size is large enough. Similarly, for outer allocations (which may be between inner and edge allocations), QPSK and $\pi/2$ BPSK for DFT-s-OFDM may be ACLR or SEM limited. Depending on the scenario, there may be also other resource block regions with associated MPR and/or other max/min transmit power -related requirements.

At least some example embodiments of the present disclosure therefore provide a realization for trellis coding to transmit a binary data sequence using the symbols of the QPSK constellation. The trellis coding may be used to avoid sharp phase transitions in a generated symbol sequence. The generated symbol sequence may cover an entire transmission. Alternatively, or in addition, phase interpolation may be applied to a trellis-coded signal, instead of linear FDSS, for generating an oversampled signal with a reduced amplitude and phase variations.

In some example embodiments, the trellis coding and phase interpolation may be used together to greatly reduce both, the OOB emissions and the PAPR of a transmitted signal. These advantages may be achieved without bandwidth extension (i.e., using M subcarriers in a DFT-s-OFDM signal for transmitting *M* bits). However, in some example embodiments, bandwidth extension may be applied to further enhance these advantages. Furthermore, the use of trellis coding makes it possible to use effective sequence detection methods, such as Soft-Output Viterbi Algorithm, SOVA, or Bahl-Cocke-Jelinek-Raviv, BCJR -algorithm, for soft detection of a transmitted symbol sequence. The use of such effective detection methods enables improved link performance.

In some example embodiments, both the OOB and PAPR, may be improved if sharp phase transitions (consecutive $+\pi/2$ and $-\pi/2$) are avoided using a two-state trellis code as follows:

- After phase transition 0, phase transitions $-\pi/2$ and $+\pi/2$ are allowed;
- After phase transition $-\pi/2$, phase transitions $-\pi/2$ and 0 are allowed; and
- After phase transition $+\pi/2$, phase transitions $+\pi/2$ and 0 are allowed.

The wireless transmitter, such as UE 110 or wireless network node 120, may thus generate, for a binary data sequence, a sequence of trellis-coded modulation symbols in a complex QPSK constellation by means of the trellis code. After that, the wireless transmitter may generate a DFT-precoded OFDM signal based at least on the sequence of trellis-coded modulation symbol. The wireless transmitter may then perform a transmission based on the generated DFT-precoded OFDM signal, wherein phase transitions between two successive trellis-coded modulation symbols of the sequence are determined by the trellis code (and are equal to 0, $+\pi/2$ or $-\pi/2$), and wherein an absolute difference between two phase transitions successively determined by the trellis code is at most $\pi/2$.

In some example embodiments, bit rates higher than 1 bit per modulation symbol may be considered. However, example embodiments of the present disclosure may be particularly beneficial for 1 bit per symbol case. For example, 1 bit per symbol case may be particularly beneficial for 6G, if the target is to achieve $\pi/2$ BPSK data rate with significantly improved PAPR and OOB.

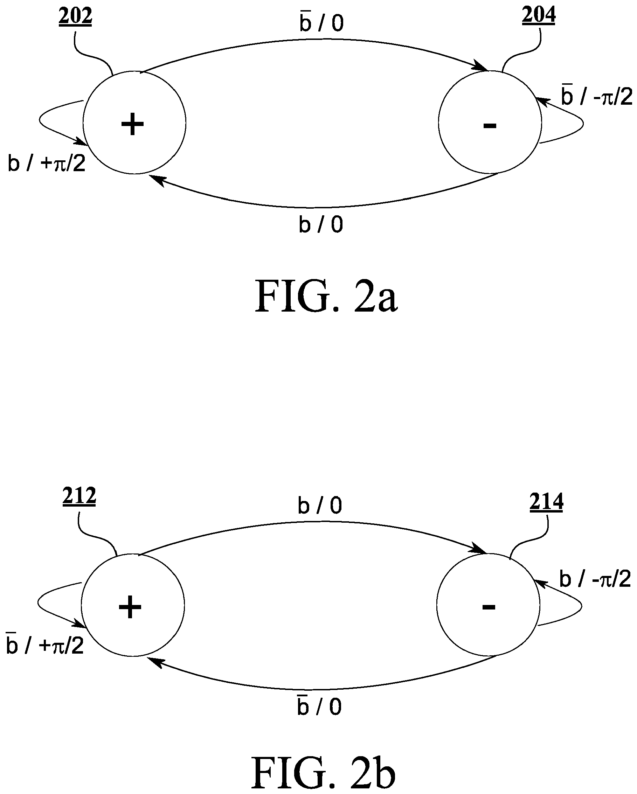

FIG. 2a illustrates a first example of bit mapping and phase transition in accordance with at least some example embodiments. FIG. 2b illustrates a second example of bit mapping and phase transition in accordance with at least some example embodiments. More specifically, FIGs. 2a and 2b illustrate the bit mapping and phase transition diagrams of two alternative recursive trellis-coding processes. In FIGs. 2a and 2b, $b$ and $\bar{b}$ indicate that the current binary value that is being encoded is equal to the previously encoded binary value or its complement, respectively. A first state of the trellis-coding processes is denoted by "+", and a second state of the trellis-coding processes is denoted by "-". That is, FIGs. 2a and 2b illustrate trellis codes which are two-states recursive trellis codes comprising first states 202 and 212, and second states 204 and 214, respectively. A wireless transmitter, such as UE 110 or wireless network node 120 of FIG. 1, may generate one trellis-coded modulation symbol of the sequence of trellis-coded modulation symbols per one bit of the binary data sequence.

FIG. 2a depicts a first state trellis diagram for generating a sequence of trellis-coded modulation symbols from a binary data sequence. The complex modulation symbols are selected from {1, j, -1, -j } complex constellation. The trellis encoder is initialized in first state 202, and binary value '1' and complex modulation symbol ' 1' are assumed as starting values (other initialization choices are possible). The transmitter may determine phase transitions for the successive trellis-coded modulation symbols as follows. If the first binary value in the binary data sequence to be encoded is '1', i.e. the same value (b) as the initial binary value, phase transition may be '$+\pi/2$', which corresponds to complex modulation symbol 'j' (if starting from complex modulation symbol '1', and positive angles are counterclockwise), and the transmitter may stay in first state 202. Else, if the first binary value in the binary data sequence to be encoded is '0', i.e. a different value ($\bar{b}$) than the initial binary value, phase transition may be '0', which corresponds to the same modulation symbol '1', and the transmitter may move to second state 204. Thus, a phase transition for generating a respective trellis-coded modulation symbol when transiting from first state 202 to second state 204 may be equal to 0. A phase transition for generating a respective trellis-coded modulation symbol when transiting from first state 202 back to first state 202 (or equivalently when staying in first state 202) may be equal to $+\pi/2$.

Assuming the previous binary value '0' was encoded as complex modulation symbol '1', and assuming the transmitter is in second state 204, if the next binary value in the binary data sequence to be encoded is '1', i.e. a different value ($\bar{b}$) than the previous binary value, phase transition may be '$\pi/2$', which corresponds to complex modulation symbol '-j', and the transmitter may stay in second state 204. Else, if the next binary value in the binary data sequence to be encoded is '0', i.e. the same value (b) as the previous binary value, then phase transition may be '0', which corresponds to complex modulation symbol ' 1', and the transmitter may move to first state 202. Thus, a phase transition for generating a respective trellis-coded modulation symbol when transiting from second state 204 to first state 202 may be equal to 0. A phase transition for generating a respective trellis-coded modulation symbol when transiting from second state 204 back to second state 204 (or equivalently when staying in second state 204) may be equal to $-\pi/2$. From first state 202, the operation of the transmitter may continue again by determining a phase transition for the next trellis-coded modulation symbol as before.

FIG. 2b depicts a second state trellis diagram for generating a sequence of trellis-coded modulation symbols from a binary data sequence The complex modulation symbols are again selected from {1, j, -1, -j } complex constellation. The trellis encoder is initialized in first state 212, and binary value '1' and complex modulation symbol '1' are assumed as starting values (other initialization choices are possible). The transmitter may determine phase transitions for the successive trellis-coded modulation symbols as follows. If the first binary value in the binary data sequence to be encoded is '0', i.e. a different value ($\bar{b}$) than initial binary value, phase transition may be '$+\pi/2$', which corresponds to complex modulation symbol 'j', and the transmitter may stay in first state 212. However, if the first binary value in the binary data sequence to be encoded is '1', i.e. the same value (b) as initial binary value, phase transition may be '0', which corresponds to the same modulation symbol '1', and the transmitter may move to second state 214. Thus, a phase transition for generating a respective trellis-coded modulation symbol when transiting from first state 212 to second state 214 may be equal to 0. A phase transition for generating a respective trellis-coded modulation symbol when transiting from first state 212 back to first state 212 (or equivalently when staying in first state 212) may be equal to $+\pi/2$.

Assuming the previous binary value '1' was encoded as modulation symbol '1', and assuming the transmitter is in second state 214, if the next binary value in the binary data sequence to be encoded is '1', i.e. the same value ($b$) as the previous binary value, phase transition may be '$\pi/2$', which corresponds to complex modulation symbol '-j', and the transmitter may stay in second state 214. Else, if the next binary value in the binary data sequence to be encoded is '0', i.e. a different value ($\overline{b}$) than the previous binary value, phase transition may be '0', which corresponds to complex modulation symbol '1', and the transmitter may move to first state 212. Thus, a phase transition for generating a respective trellis-coded modulation symbol when transiting from second state 214 to first state 212 may be equal to 0. A phase transition for generating a respective trellis-coded modulation symbol when transiting from second state 214 back to second state 214 (or equivalently when staying in second state 214) may be equal to $-\pi/2$. From first state 212, the operation of the transmitter may continue again by determining a phase transition for the next trellis-coded modulation symbol as before.

In some example embodiments, the wireless transmitter may determine that a first phase transition for generating a first trellis-coded modulation symbol of the sequence is 0. In such a case, the wireless transmitter may determine, based on determining that the first phase transition is 0, that a second phase transition for generating a second successive trellis-coded modulation symbol of the sequence is $-\pi/2$, 0 or $+\pi/2$.

In some example embodiments, the wireless transmitter may determine that a first phase transition for generating a first trellis-coded modulation symbol of the sequence is $-\pi/2$ (in second states 204, 214). In such a case, the wireless transmitter may determine, based on determining that the first phase transition is $-\pi/2$, that a second phase transition for generating a second successive trellis-coded modulation symbol of the sequence is $-\pi/2$ or 0 (to stay in second states 204, 214 or to move to first states 202, 212).

In some example embodiments, the wireless transmitter may determine that a first phase transition for generating a first trellis-coded modulation symbol of the sequence is $+\pi/2$ (in first states 202, 212). In such a case, the wireless transmitter may determine, based on determining that the first phase transition is $+\pi/2$, that a second phase transition for generating a second successive trellis-coded modulation symbol of the sequence is $+\pi/2$ or 0 (to stay in first states 202, 212 or to move to second states 204, 214).

Thus, there may be one state: "+" (first states 202, 212) from which the next phase transition is $+\pi/2$ or 0, and one state "-" (second states 204, 214) from which the phase transition is $-\pi/2$ or 0. The aim of the bit mapping may be to minimize the Hamming distance of sequences with a small Euclidean distance. As an example, a binary data sequence {1 1 0 0 1 0} may correspond to a phase transition sequence {$\pi/2$, $\pi/2$, 0, 0, 0, $-\pi/2$}, e.g., assuming that the coding process starts from state '+' and binary value '1'. After trellis coding, and assuming that the initial complex modulation symbol is '1', the sequence may appear as a complex QPSK symbol sequence {j, -1, -1, -1, -1, j}.

In some example embodiments, the complex modulation symbols may be selected from

$$\{(1 + j)/\sqrt{2}, (-1 + j)/\sqrt{2}, (-1 - j)/\sqrt{2}, (1 - j)/\sqrt{2} \quad \}$$

complex constellation instead of {1, j, -1, -j } complex constellation.

In some example embodiments, considering the phase transition diagrams of FIGs. 2a and 2b, there may be four alternative bit mappings. However, the two additional bit mappings, which are not illustrated in FIGs. 2a and 2b, may result in much worse link performance.

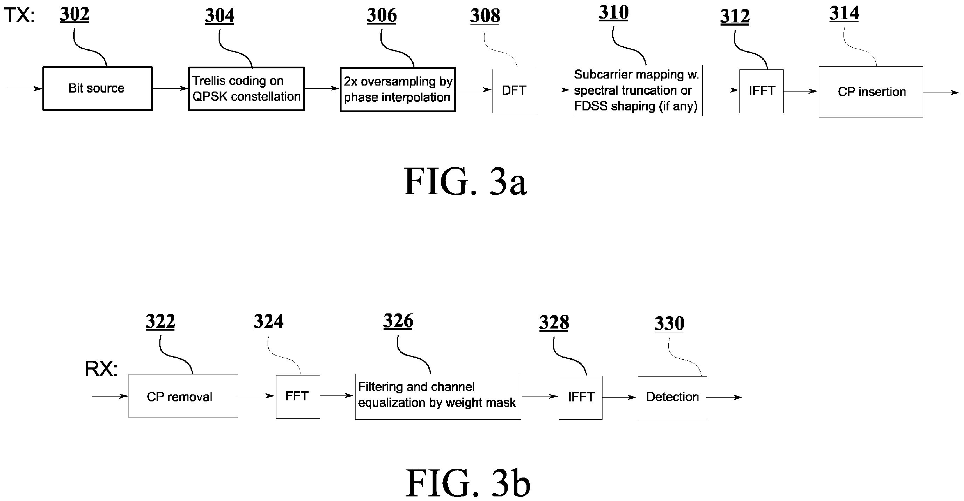

FIG. 3a illustrates an example of operation of a transmitter in accordance with at least some example embodiments. FIG. 3b illustrates an example of operation of a receiver in accordance with at least some example embodiments. Thus, FIGs 3a and 3b illustrate together an overall transmission scheme, comprising a baseband transmitter and receiver signal processing excluding error control coding elements. The wireless transmitter of FIG. 3a may be UE 110 or wireless network node 120, while the wireless receiver of FIG. 3b may be wireless network node 120 or UE 110, respectively.

With reference to FIG. 3a, the transmitter may, at step 302, determine a bit source. At step 304, transmitter may perform trellis coding on QPSK constellation, e.g., according to FIG. 2a or 2b. At step 306, the transmitter may perform 2x oversampling by phase interpolation. So after trellis-coding, the transmitter may oversample the signal by a factor of two using phase interpolation. Phase interpolation may be done by inserting new, additional modulation symbols interleaved with the sequence of trellis-coded modulation symbols. The interleaved modulation symbols may have a same amplitude as a preceding and successive trellis-coded modulation symbols, and a phase interpolated from phases of the preceding and successive trellis-coded modulation symbols. Such phase interpolation might not be a linear filtering process, but it may greatly reduce the PAPR and OOB emission in comparison to linear FDSS.

After phase interpolation, for example a bit sequence of {1 1 0 0 1 0} may appear as a complex symbol sequence {j, (-1+j)/$\sqrt{2}$, -1, -1, -1, -1, -1, -1, (-1+j)/$\sqrt{2}$, j}. Additionally, a cyclic extension (i.e., interpolation between first and last input samples) may be used to obtain 2-times oversampled sequence of length $2M$. Continuing the previous example, the resulting length-12 complex symbol sequence is then {j, (-1+j)/$\sqrt{2}$, -1, -1, -1, -1, -1, -1, (-1+j)/$\sqrt{2}$, j, j }.

At step 308, the transmitter may perform DFT processing. The DFT may be taken of the oversampled symbol sequence, wherein the bandwidth of the oversampled symbol sequence may be twice the bandwidth of initial symbol sequence.

At step 310, the transmitter may perform subcarrier mapping with spectral truncation or FDSS shaping (if any). FDSS may be applied to the oversampled DFT sequence. However, in some example embodiments, the DFT-domain sequence may be truncated to a preferred bandwidth by mapping $M+E$ DFT bins, which may be centered around the DC bin of the DFT-domain sequence. For example, $M$ bins may follow the existing frequency domain resource allocation (received from wireless network node 120 by UE 110), while the bandwidth extension may be made by reserving $E/2$ bins in both sides of the $M$ bins. In some example embodiments, $M$ may be a number of bits mapped to a DFT-s-OFDM symbol (i.e., denote also the length of the sequence of modulation symbols before oversampling), and $E$ may correspond to an excess band size, if any. The zero-excess band case ($E=0$) may be preferred, but increasing excess band ($0 < E \leq M$) provides lower PAPR and lower OOB emissions. Thus, $E$ may be a positive integer with $0 \leq E \leq M$.

At step 312, the transmitter may perform IFFT processing. At step 314, the transmitter may perform CP insertion. The signal may be transmitted after this step. The transmitter may thus perform a transmission based on the generated DFT-precoded OFDM signal, wherein phase transitions between two successive trellis-coded modulation symbols of the sequence are determined by the trellis code, and wherein an absolute difference between two phase transitions successively-determined by the trellis code is at most $\pi/2$.

In some example embodiments, the transmitter may generate the DFT-precoded OFDM signal based at least on the sequence of trellis-coded modulation symbols and on the interleaved modulation symbols, inserted at step 306.

With reference to FIG. 3b, a receiver may, at step 322, receive the DFT-precoded signal and perform CP removal. At step 324, the receiver may perform FFT processing. At step 326, the receiver may perform filtering and channel equalization by a weight mask. At step 328, the receiver may perform IFFT. At step 330, the receiver may perform detection, i.e. determine a sequence of trellis-coded modulation symbols from the DFT-precoded OFDM signal, and determine a binary data sequence from the sequence of trellis-coded modulation symbols and based on a trellis code that was used to generate the sequence of trellis-coded modulation symbols, wherein phase transitions between two successive trellis-coded modulation symbols of the sequence are determined by the trellis code, and wherein an absolute difference between two phase transitions successively-determined by the trellis code is at most $\pi/2$.

In some example embodiments, the transmitter may determine whether a size of an allocation of the transmission in frequency-domain is below a threshold. When the size of the allocation of the transmission is below or equal to the threshold, the transmitter may perform insertion of additional modulation symbols interleaved with the sequence of trellis-coded modulation symbols, wherein the interleaved modulation symbols have a same amplitude as a preceding and successive trellis-coded modulation symbols, and a phase interpolated from phases of the preceding and successive trellis-coded modulation symbols. The transmitter may then generate the DFT-precoded OFDM signal based at least on the sequence of trellis-coded modulation symbols and on the interleaved modulation symbols. Alternatively, the transmitter may consider the allocation as invalid when the size of the allocation of the transmission is above the threshold.

For example, insertion of the interleaved modulation symbols may be limited to allocation sizes $L_{PRB,max} = 0.5^* L_{PRB,max\_nominal}$ (PRBs), wherein the nominal size ($L_{PRB,max\_nominal}$) may be one of the following:

- Maximum bandwidth part size defined, e.g., in 3GPP standard specifications (e.g. 275 RBs in NR); or
- Maximum allocation size applicable to other uplink transmission schemes (such as DFT-s-OFDM without trellis coding) UE 110 may apply.

Thus, the threshold for inserting the interleaved modulation symbols may be half of a maximum allocation size of the transmission in frequency-domain, such as the maximum bandwidth part size or the maximum allocation size applicable.

In some example embodiments, the obtained maximum allocation size ($L_{PRS,max}$) may need to follow the existing DFT size rule, e.g., a number of PRBs being realizable as $L_{PRB} = 2^a \times 3^b \times 5^c$, wherein a, b and c may be integers. Therefore, it may be possible to use DFT sizes which may be already existing in the implementations. In such a case, there would be no need for additional hardware.

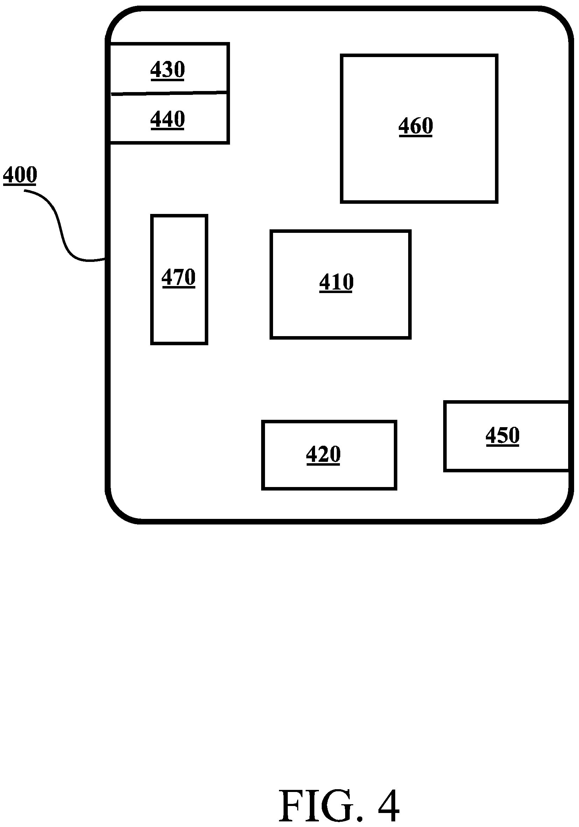

FIG. 4 illustrates an example apparatus capable of supporting at least some example embodiments. Illustrated is device 400, which may comprise, for example, UE 110 or wireless network node 120, or a control device configured to control the functioning thereof, possibly when installed therein. Comprised in device 400 is processor 410, which may comprise, for example, a single- or multi-core processor wherein a single-core processor comprises one processing core and a multi-core processor comprises more than one processing core. Processor 410 may comprise, in general, a control device. Processor 410 may comprise more than one processor. Processor 410 may be a control device. A processing core may comprise, for example, a Cortex-A8 processing core manufactured by ARM Holdings or a Steamroller processing core produced by Advanced Micro Devices Corporation. Processor 410 may comprise at least one Qualcomm Snapdragon and/or Intel Atom processor. Processor 410 may comprise at least one application-specific integrated circuit, ASIC. Processor 410 may comprise at least one field-programmable gate array, FPGA. Processor 410 may be means for performing method steps in device 400. Processor 410 may be configured, at least in part by computer instructions, to perform actions.

A processor may comprise circuitry, or be constituted as circuitry or circuitries, the circuitry or circuitries being configured to perform phases of methods in accordance with example embodiments described herein. As used in this application, the term "circuitry" may refer to one or more or all of the following: (a) hardware-only circuit implementations, such as implementations in only analog and/or digital circuitry, and (b) combinations of hardware circuits and software, such as, as applicable: (i) a combination of analog and/or digital hardware circuit(s) with software/firmware and (ii) any portions of hardware processor(s) with software (including digital signal processor(s)), software, and memory(ies) that work together to cause an apparatus, such as a mobile phone or server, to perform various functions) and (c) hardware circuit(s) and or processor(s), such as a microprocessor(s) or a portion of a microprocessor(s), that requires software (e.g., firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in server, a cellular network device, or other computing or network device.

Device 400 may comprise memory 420. Memory 420 may comprise random-access memory and/or permanent memory. Memory 420 may comprise at least one RAM chip. Memory 420 may comprise solid-state, magnetic, optical and/or holographic memory, for example. Memory 420 may be at least in part accessible to processor 410. Memory 420 may be at least in part comprised in processor 410. Memory 420 may be means for storing information. Memory 420 may comprise computer instructions that processor 410 is configured to execute. When computer instructions configured to cause processor 410 to perform certain actions are stored in memory 420, and device 400 overall is configured to run under the direction of processor 410 using computer instructions from memory 420, processor 410 and/or its at least one processing core may be considered to be configured to perform said certain actions. Memory 420 may be at least in part comprised in processor 410. Memory 420 may be at least in part external to device 400 but accessible to device 400.

Device 400 may comprise a transmitter 430. Device 400 may comprise a receiver 440. Transmitter 430 and receiver 440 may be configured to transmit and receive, respectively, information in accordance with at least one cellular or non-cellular standard. Transmitter 430 may comprise more than one transmitter. Receiver 440 may comprise more than one receiver. Transmitter 430 and/or receiver 440 may be configured to operate in accordance with Global System for Mobile communication, GSM, Wideband Code Division Multiple Access, WCDMA, Long Term Evolution, LTE, and/or 5G/NR standards, for example.

Device 400 may comprise a Near-Field Communication, NFC, transceiver 450. NFC transceiver 450 may support at least one NFC technology, such as Bluetooth, Wibree or similar technologies.

Device 400 may comprise User Interface, UI, 460. UI 460 may comprise at least one of a display, a keyboard, a touchscreen, a vibrator arranged to signal to a user by causing device 400 to vibrate, a speaker and a microphone. A user may be able to operate device 400 via UI 460, for example to accept incoming telephone calls, to originate telephone calls or video calls, to browse the Internet, to manage digital files stored in memory 420 or on a cloud accessible via transmitter 430 and receiver 440, or via NFC transceiver 450, and/or to play games.

Device 400 may comprise or be arranged to accept a user identity module 470. User identity module 470 may comprise, for example, a Subscriber Identity Module, SIM, card installable in device 400. A user identity module 470 may comprise information identifying a subscription of a user of device 400. A user identity module 470 may comprise cryptographic information usable to verify the identity of a user of device 400 and/or to facilitate encryption of communicated information and billing of the user of device 400 for communication effected via device 400.

Processor 410 may be furnished with a transmitter arranged to output information from processor 410, via electrical leads internal to device 400, to other devices comprised in device 400. Such a transmitter may comprise a serial bus transmitter arranged to, for example, output information via at least one electrical lead to memory 420 for storage therein. Alternatively to a serial bus, the transmitter may comprise a parallel bus transmitter. Likewise processor 410 may comprise a receiver arranged to receive information in processor 410, via electrical leads internal to device 400, from other devices comprised in device 400. Such a receiver may comprise a serial bus receiver arranged to, for example, receive information via at least one electrical lead from receiver 440 for processing in processor 410. Alternatively to a serial bus, the receiver may comprise a parallel bus receiver.

Device 400 may comprise further devices not illustrated in FIG. 4. For example, where device 400 comprises a smartphone, it may comprise at least one digital camera. Some devices 400 may comprise a back-facing camera and a front-facing camera, wherein the back-facing camera may be intended for digital photography and the front-facing camera for video telephony. Device 400 may comprise a fingerprint sensor arranged to authenticate, at least in part, a user of device 400. In some example embodiments, device 400 lacks at least one device described above. For example, some devices 400 may lack a NFC transceiver 450 and/or user identity module 470.

Processor 410, memory 420, transmitter 430, receiver 440, NFC transceiver 450, UI 460 and/or user identity module 470 may be interconnected by electrical leads internal to device 400 in a multitude of different ways. For example, each of the aforementioned devices may be separately connected to a master bus internal to device 400, to allow for the devices to exchange information. However, as the skilled person will appreciate, this is only one example and depending on the example embodiment, various ways of interconnecting at least two of the aforementioned devices may be selected without departing from the scope of the example embodiments.

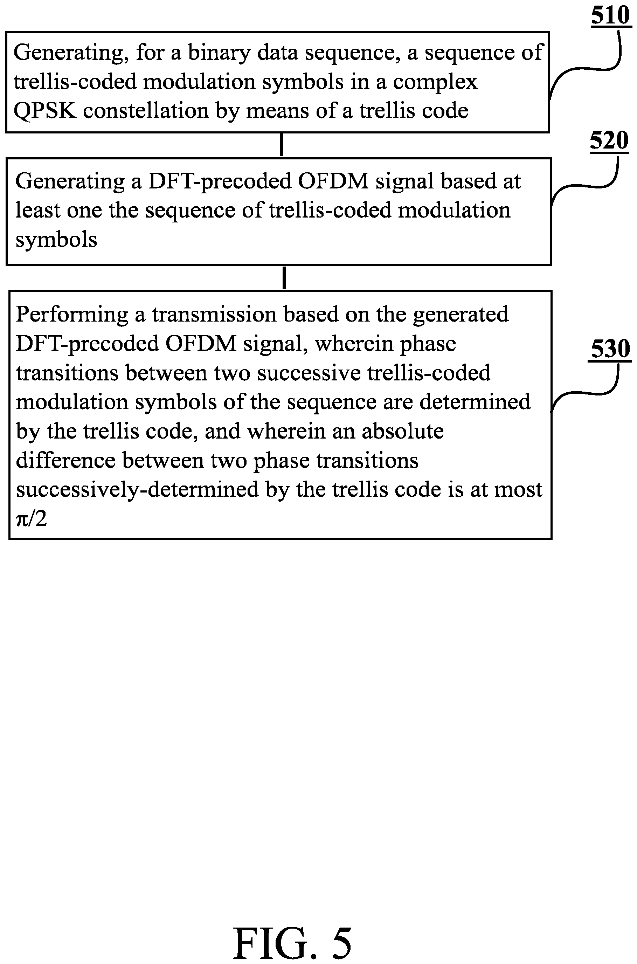

FIG. 5 is a flow graph of a first method in accordance with at least some example embodiments. The steps of the first method may be performed by any wireless transmitter, such as UE 110 or wireless network node 120, or by a control device configured to control the functioning thereof, possibly when installed therein.

The first method may comprise, at step 510, generating, for a binary data sequence, a sequence of trellis-coded modulation symbols in a complex QPSK constellation by means of a trellis code. The first method may also comprise, at step 520, generating a DFT-precoded OFDM signal based at least on the sequence of trellis-coded modulation symbols. Finally, the first method may comprise, at step 530, performing a transmission based on the generated DFT-precoded OFDM signal, wherein phase transitions between two successive trellis-coded modulation symbols of the sequence are determined by the trellis code, and wherein an absolute difference between two phase transitions successively-determined by the trellis code is at most $\pi/2$.

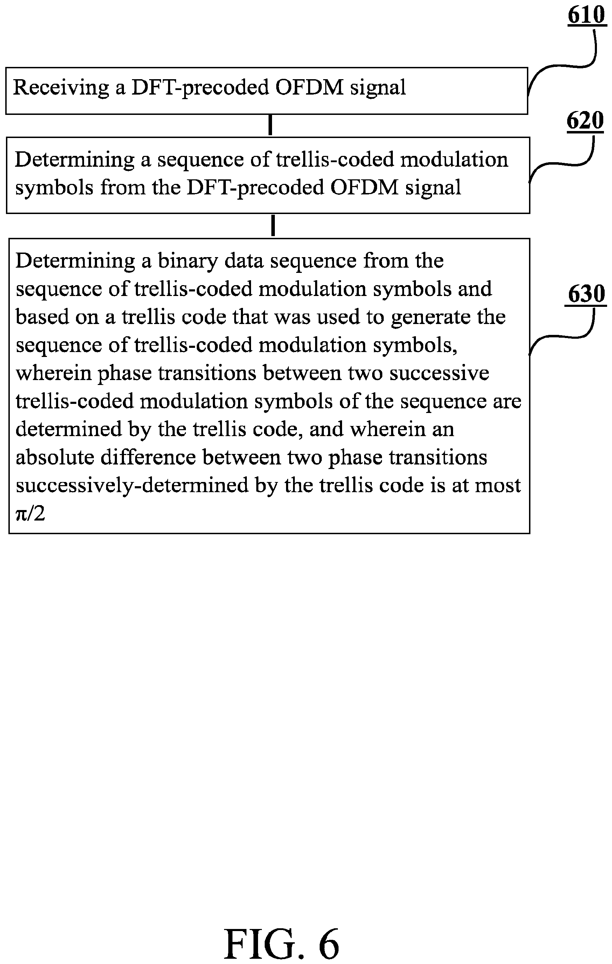

FIG. 6 is a flow graph of a second method in accordance with at least some example embodiments. The steps of the second method may be performed by any wireless receiver, such as UE 110 or wireless network node 120, or by a control device configured to control the functioning thereof, possibly when installed therein.

The second method may comprise, at step 610, receiving a DFT-precoded OFDM signal. The second method may also comprise, at step 620, determining a sequence of trellis-coded modulation symbols from the DFT-precoded OFDM signal. Finally, the second method may comprise, at step 630, determining a binary data sequence from the sequence of trellis-coded modulation symbols and based on a trellis code that was used to generate the sequence of trellis-coded modulation symbols, wherein phase transitions between two successive trellis-coded modulation symbols of the sequence are determined by the trellis code, and wherein an absolute difference between two phase transitions successively-determined by the trellis code is at most $\pi/2$.

It is to be understood that the example embodiments disclosed are not limited to the particular structures, process steps, or materials disclosed herein, but are extended to equivalents thereof as would be recognized by those ordinarily skilled in the relevant arts. It should also be understood that terminology employed herein is used for the purpose of describing particular example embodiments only and is not intended to be limiting.

Reference throughout this specification to one example embodiment or an example embodiment means that a particular feature, structure, or characteristic described in connection with the example embodiment is included in at least one example embodiment. Thus, appearances of the phrases "in one example embodiment" or "in an example embodiment" in various places throughout this specification are not necessarily all referring to the same example embodiment. Where reference is made to a numerical value using a term such as, for example, about or substantially, the exact numerical value is also disclosed.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary. In addition, various example embodiments and examples may be referred to herein along with alternatives for the various components thereof. It is understood that such example embodiments, examples, and alternatives are not to be construed as de facto equivalents of one another, but are to be considered as separate and autonomous representations.

In an example embodiment, an apparatus, such as, for example, UE 110 or wireless network node 120, may comprise means for carrying out the example embodiments described above and any combination thereof.

In an example embodiment, a computer program may be configured to cause a method in accordance with the example embodiments described above and any combination thereof. In an example embodiment, a computer program product, embodied on a non-transitory computer readable medium, may be configured to control a processor to perform a process comprising the example embodiments described above and any combination thereof.

In an example embodiment, an apparatus, such as, for example, UE 110 or wireless network node 120, may comprise at least one processor, and at least one memory including computer program code, wherein the at least one memory and the computer program code are configured to, with the at least one processor, cause the apparatus at least to perform the example embodiments described above and any combination thereof.

Furthermore, the described features, structures, or characteristics may be combined in any suitable manner in one or more example embodiments. In the preceding description, numerous specific details are provided, such as examples of lengths, widths, shapes, etc., to provide a thorough understanding of example embodiments of the disclosure.

One skilled in the relevant art will recognize, however, that the disclosure can be practiced without one or more of the specific details, or with other methods, components, materials, etc. In other instances, well-known structures, materials, or operations are not shown or described in detail to avoid obscuring aspects of the disclosure.

While the forgoing examples are illustrative of the principles of the example embodiments in one or more particular applications, it will be apparent to those of ordinary skill in the art that numerous modifications in form, usage and details of implementation can be made without the exercise of inventive faculty, and without departing from the principles and concepts of the disclosure. Accordingly, it is not intended that the disclosure be limited, except as by the claims set forth below.

The verbs "to comprise" and "to include" are used in this document as open limitations that neither exclude nor require the existence of also un-recited features. The features recited in depending claims are mutually freely combinable unless otherwise explicitly stated. Furthermore, it is to be understood that the use of "a" or "an", that is, a singular form, throughout this document does not exclude a plurality.

INDUSTRIAL APPLICABILITY

At least some example embodiments find industrial application in cellular communication networks, for example in 3GPP networks.

ACRONYMS LIST

| | |
|---|---|
| 3GPP | 3rd Generation Partnership Project |
| ACLR | Adjacent Channel Leakage Ratio |
| BCJR | Bahl-Cocke-Jelinek-Raviv |
| BPSK | Binary Phase Shift Keying |
| BS | Base Station |
| CCDF | Complementary Cumulative Distribution Function |
| DFT | Discrete Fourier Transform |
| DU | Distributed Unit |
| eMBB | Enhanced Mobile Broadband |
| FDSS | Frequency Domain Spectrum Shaping |
| GSM | Global System for Mobile communication |
| IAB | Integrated Access and Backhaul |
| IBE | In-band Emissions |
| IFFT | Inverse Fast Fourier Transform |
| IoT | Internet of Things |
| LPWA | Low Power Wide Area |
| LTE | Long-Term Evolution |
| M2M | Machine-to-Machine |
| MPR | Maximum Power Reduction |
| MT | Mobile Termination |
| NFC | Near-Field Communication |
| NR | New Radio |
| OBO | Output back-off |
| OFDM | Orthogonal Frequency Division Multiplexing |
| OOB | Out-of-band |
| PAPR | Peak-to-Average Power Ratio |
| PRB | Physical Resource Block |
| PUCCH | Physical Uplink Control Channel |
| PUSCH | Physical Uplink Shared Channel |
| QAM | Quadrature Amplitude Modulation |
| QPSK | Quadrature Phase Shift Keying |
| RAT | Radio Access Technology |
| RB | Resource Block |
| RF | Radio Frequency |
| RRC | Radio Resource Control |
| SEM | Spectral Emission Mask |

| SOVA | Soft-Output Viterbi Algorithm |
| TRP | Transmission and Reception Point |
| UE | User Equipment |
| UI | User Interface |
| WCDMA | Wideband Code Division Multiple Access |
| WiMAX | Worldwide Interoperability for Microwave Access |
| WLAN | Wireless Local Area Network |

REFERENCE SIGNS LIST

| 110 | UE |
| 115, 125, 135 | Interfaces |
| 120 | Wireless network node |
| 130 | Core network |
| 202, 212 | First states |
| 204, 214 | Second states |
| 302-314 | Steps in FIG. 3a |
| 322 - 330 | Steps in FIG. 3b |
| 400 - 470 | Structure of the apparatus of FIG. 4 |
| 510 - 530 | Phases of the first method in FIG. 5 |
| 610-630 | Phases of the second method in FIG. 6 |

**Claims**

1. An apparatus comprising at least one processor, and at least one memory storing instructions that, when executed by the at least one processor, cause the apparatus at least to:

   - generate, for a binary data sequence, a sequence of trellis-coded modulation symbols in a complex Quadrature Phase Shift Keying, QPSK, constellation by means of a trellis code;
   - generate a Discrete Fourier Transform, DFT, -precoded Orthogonal Frequency Division Multiplexing, OFDM, signal based at least on the sequence of trellis-coded modulation symbols; and
   - perform a transmission based on the generated DFT-precoded OFDM signal, wherein phase transitions between two successive trellis-coded modulation symbols of the sequence are determined by the trellis code, and wherein an absolute difference between two phase transitions successively-determined by the trellis code is at most $\pi/2$.

2. The apparatus according to claim 1, wherein the trellis code is a two-states recursive trellis code comprising a first state and a second state, wherein a phase transition for generating a respective trellis-coded modulation symbol when transiting from the first state to the second state or from the second state to the first state is equal to 0, wherein a phase transition for generating a respective trellis-coded modulation symbol when transiting from the first state back to the first state is equal to $+\pi/2$, and wherein a phase transition for generating a respective trellis-coded modulation symbol when transiting from the second state back to the second state is equal to $-\pi/2$.

3. The apparatus according to claim 1 or claim 2, wherein the apparatus is further caused to:

   - determine that a first phase transition for generating a first trellis-coded modulation symbol of the sequence is 0; and
   - determine, based on determining that the first phase transition is 0, that a second phase transition for generating a second successive trellis-coded modulation symbol of the sequence is $-\pi/2$, 0 or $+\pi/2$.

4.  The apparatus according to any of the preceding claims, wherein the apparatus is further caused to:

    - determine that a first phase transition for generating a first trellis-coded modulation symbol of the sequence is -π/2; and
    - determine, based on determining that the first phase transition is -π/2, that a second phase transition for generating a second successive trellis-coded modulation symbol of the sequence is -π/2 or 0.

5.  The apparatus according to any of the preceding claims, wherein the apparatus is further caused to:

    - determine that a first phase transition for generating a first trellis-coded modulation symbol of the sequence is +π/2; and
    - determine, based on determining that the first phase transition is +π/2, that a second phase transition for generating a second successive trellis-coded modulation symbol of the sequence is +π/2 or 0.

6.  The apparatus according to any of the preceding claims, wherein the apparatus is further caused to:

    - insert additional modulation symbols interleaved with the sequence of trellis-coded modulation symbols, wherein the interleaved modulation symbols have a same amplitude as a preceding and successive trellis-coded modulation symbols, and a phase interpolated from phases of the preceding and successive trellis-coded modulation symbols; and
    - generate the DFT-precoded OFDM signal based at least on the sequence of trellis-coded modulation symbols and on the interleaved modulation symbols.

7.  The apparatus according to claim 6, wherein the apparatus is further caused to:

    - generate the DFT-precoded OFDM signal by truncating a DFT-domain sequence to a preferred bandwidth of size $M+E$ DFT bins to an Inverse Fast Fourier Transform, IFFT, input, wherein $M$ denotes a length of the sequence, and $E$ denotes a positive integer with $0 \leq E \leq M$.

8.  The apparatus according to claim 7, wherein the $M+E$ DFT bins are centered around a DC bin of the DFT-domain sequence.

9.  The apparatus according to any of claims 6 to 8, wherein the apparatus is further caused to:

    - determine whether a size of an allocation of the transmission in frequency-domain is below a threshold; and
    - perform said insertion when the size of the allocation of the transmission is below or equal to the threshold.

10. The apparatus according to any of claims 6 to 9, wherein the apparatus is further caused to:

    - determine whether a size of an allocation of the transmission in frequency-domain is below a threshold; and
    - consider the allocation as invalid when the size of the allocation of the transmission is above the threshold.

11. The apparatus according to claim 9 or claim 10, wherein the threshold is half of a maximum allocation size of the transmission in frequency-domain.

12. The apparatus according to any of the preceding claims, wherein the apparatus is further caused to:

    - generate one trellis-coded modulation symbol of the sequence of trellis-coded modulation symbols per one bit of the binary data sequence.

13. A method, comprising:

    - generating, for a binary data sequence, a sequence of trellis-coded modulation symbols in a complex Quadrature Phase Shift Keying, QPSK, constellation by means of a trellis code,
    - generating a Discrete Fourier Transform, DFT, -precoded, Orthogonal Frequency Division Multiplexing, OFDM signal based at least on the sequence of trellis-coded modulation symbols; and
    - performing a transmission based on the generated DFT-precoded OFDM signal, wherein phase transitions between two successive trellis-coded modulation symbols of the sequence are determined by the trellis code, and wherein an absolute difference between two phase transitions successively-determined by the trellis code is at most $\pi/2$.

14. An apparatus comprising at least one processor, and at least one memory storing instructions that, when executed by the at least one processor, cause the apparatus at least to:

   - receive a Discrete Fourier Transform, DFT, -precoded Orthogonal Frequency Division Multiplexing, OFDM signal,
   - determine a sequence of trellis-coded modulation symbols from the DFT-precoded OFDM signal; and
   - determine a binary data sequence from the sequence of trellis-coded modulation symbols and based on a trellis code that was used to generate the sequence of trellis-coded modulation symbols, wherein phase transitions between two successive trellis-coded modulation symbols of the sequence are determined by the trellis code, and wherein an absolute difference between two phase transitions successively-determined by the trellis code is at most $\pi/2$.

15. The apparatus according to claim 14, wherein the trellis code is a two-states recursive trellis code comprising a first state and a second state, wherein a phase transition for decoding a respective trellis-coded modulation symbol when transiting from the first state to the second state or from the second state to the first state is equal to 0, wherein a phase transition for decoding a respective trellis-coded modulation symbol when transiting from the first state back to the first state is equal to $+\pi/2$, and wherein a phase transition for decoding a respective trellis-coded modulation symbol when transiting from the second state back to the second state is equal to $-\pi/2$.

16. A method, comprising:

   - receiving a Discrete Fourier Transform, DFT, -precoded Orthogonal Frequency Division Multiplexing, OFDM signal,
   - determining a sequence of trellis-coded modulation symbols from the DFT-precoded OFDM signal; and
   - determining a binary data sequence from the sequence of trellis-coded modulation symbols and based on a trellis code that was used to generate the sequence of trellis-coded modulation symbols, wherein phase transitions between two successive trellis-coded modulation symbols of the sequence are determined by the trellis code, and wherein an absolute difference between two phase transitions successively-determined by the trellis code is at most $\pi/2$.

FIG. 1

202 $\bar{b}$ / 0 204

+ -

b / +π/2 $\bar{b}$ / -π/2

b / 0

## FIG. 2a

212 b / 0 214

+ -

$\bar{b}$ / +π/2 b / -π/2

$\bar{b}$ / 0

## FIG. 2b

TX:

**302** Bit source

**304** Trellis coding on QPSK constellation

**306** 2x oversampling by phase interpolation

**308** DFT

**310** Subcarrier mapping w. spectral truncation or FDSS shaping (if any)

**312** IFFT

**314** CP insertion

## FIG. 3a

RX:

**322** CP removal

**324** FFT

**326** Filtering and channel equalization by weight mask

**328** IFFT

**330** Detection

## FIG. 3b

FIG. 4

**510**

Generating, for a binary data sequence, a sequence of trellis-coded modulation symbols in a complex QPSK constellation by means of a trellis code

**520**

Generating a DFT-precoded OFDM signal based at least one the sequence of trellis-coded modulation symbols

**530**

Performing a transmission based on the generated DFT-precoded OFDM signal, wherein phase transitions between two successive trellis-coded modulation symbols of the sequence are determined by the trellis code, and wherein an absolute difference between two phase transitions successively-determined by the trellis code is at most $\pi/2$

# FIG. 5

<u>**610**</u>

Receiving a DFT-precoded OFDM signal

<u>**620**</u>

Determining a sequence of trellis-coded modulation symbols from the DFT-precoded OFDM signal

Determining a binary data sequence from the sequence of trellis-coded modulation symbols and based on a trellis code that was used to generate the sequence of trellis-coded modulation symbols, wherein phase transitions between two successive trellis-coded modulation symbols of the sequence are determined by the trellis code, and wherein an absolute difference between two phase transitions successively-determined by the trellis code is at most $\pi/2$

<u>**630**</u>

# FIG. 6

Europäisches
Patentamt

European
Patent Office

Office européen
des brevets

## EUROPEAN SEARCH REPORT

**Application Number**

EP 23 21 9586

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MEDIATEK INC: "Low PAPR Modulation Design for NR UL", 3GPP DRAFT; R1-1702729-LOW PAPR MODULATION DESIGN FOR NR UL_FINAL, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRAN , vol. RAN WG1, no. Athens, Greece; 20170213 - 20170217 7 February 2017 (2017-02-07), XP051221569, Retrieved from the Internet: URL:http://www.3gpp.org/ftp/tsg_ran/WG1_RL 1/TSGR1_88/Docs/ [retrieved on 2017-02-07] * Section 3. * | 1-16 | INV. H04L27/20 H03M13/25 H04L1/00 H04L27/26 |
| X | PERUGA NASARRE ISMAEL ET AL: "Constrained PSK: Energy-Efficient Modulation for Sub-THz Systems", 2020 IEEE INTERNATIONAL CONFERENCE ON COMMUNICATIONS WORKSHOPS (ICC WORKSHOPS), IEEE, 7 June 2020 (2020-06-07), pages 1-7, XP033796102, DOI: 10.1109/ICCWORKSHOPS49005.2020.9145132 [retrieved on 2020-07-20] * Section II. * * figures 1, 2 * | 1-16 | |

TECHNICAL FIELDS
SEARCHED        (IPC)

H04L
H03M

-/--

The present search report has been drawn up for all claims

| Place of search | Date of completion of the search | Examiner |
|---|---|---|
| Berlin | 28 May 2024 | Chave, Julien |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 23 21 9586

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LIU Y J ET AL: "FULLY TRANSPARENT PHASE/DOPPLER INVARIANT TRELLIS-CODED MODULATION", IEE PROCEEDINGS I. SOLID- STATE & ELECTRON DEVICES, INSTITUTION OF ELECTRICAL ENGINEERS. STEVENAGE, GB, vol. 138, no. 2, 1 April 1991 (1991-04-01), pages 105-116, XP000225625, ISSN: 0956-3776 * Sections 2., 3. and 4. * | 1-16 | |
| A | WO 2023/041163 A1 (NOKIA TECHNOLOGIES OY [FI]) 23 March 2023 (2023-03-23) * figure 2 * * paragraph [0042] - paragraph [0044] * | 1-16 | |

TECHNICAL FIELDS SEARCHED (IPC)

The present search report has been drawn up for all claims

| Place of search | Date of completion of the search | Examiner |
|---|---|---|
| Berlin | 28 May 2024 | Chave, Julien |

EPO FORM 1503 03.82 (P04C01)

EP 4 576 692 A1

**ANNEX TO THE EUROPEAN SEARCH REPORT
ON EUROPEAN PATENT APPLICATION NO.**                    EP 23 21 9586

This annex lists the patent family members relating to the patent documents cited in  the above-mentioned European search report.
The members are as contained in the European Patent Office EDP file on
The European Patent Office is in no way liable for these particulars which are merely given for the purpose of information.

28-05-2024

| Patent document cited in search report | Publication date | Patent family member(s) | Publication date |
|---|---|---|---|
| WO 2023041163 A1 | 23-03-2023 | NONE | |

EPO FORM P0459

For more details about this annex : see Official Journal of the European Patent Office, No. 12/82